# EUROPEAN PATENT APPLICATION

(11) **EP 1 724 062 A1**
(43) Date of publication of application: **22.11.2006**
(21) Application number: 06009878.7
(22) Date of filing: 12.05.2006
(51) Int. Cl.: B24B 37/04, B24D 7/14, B24D 11/04

(54) **Apparatus for polishing wafer and process for polishing wafer**

(30) Priority: 18.05.2005 JP 2005145611
(71) Applicant: SUMCO Corporation, Minato-ku Tokyo (JP)
(72) Inventor: Hashii, Tomohiro c/o Sumco Corporation, Tokyo (JP); Murayama, Katsuhiko c/o Sumco Corporation, Tokyo (JP); Koyata, Sakae c/o Sumco Corporation, Tokyo (JP); Takaishi, Kazushige c/o Sumco Corporation, Tokyo (JP)
(74) Representative: Albrecht, Thomas

(57) **Abstract**

An apparatus for polishing wafers which can reduce equipments for polishing wafers and materials for polishing, and which can simplify the polishing process and shorten the time for polishing, and a process for polishing wafers are provided. The apparatus for polishing a wafer which polishes the wafer W held by a carrier plate which rotates around an axis, by pressing and rubbing the wafer to a polishing pad disposed to a polishing platen 12 which rotates around another axis which differs from said axis, in which the polishing pad 11 is equipped with plural areas including a first area 11a and a second area 11b having hardness different from each other, each of the first 11a area and second area 11b being formed at a distribution and/or an area ratio such that the rate of the time or distance that the wafer W passes through the first area 11a during polishing to the time or distance that the wafer W passes through the second area 11b during polishing becomes a predetermined value.

## Description

### BACKGROUND OF THE INVENTION

### Field of the Invention

The present invention relates to an apparatus for polishing wafers such as integrated circuits and a process for polishing wafers.

Priority is claimed on Japanese Patent Application No. 2005-145611, filed May 18, 2005, the content of which is incorporated herein by reference.

### Description of Related Art

Generally, as for the silicon wafer of which the surface is etched, polish is performed to the surface in a polishing process. In the conventional polishing process, by performing the first polishing process which removes the coarse unevenness on the surface of a wafer using a wafer polishing apparatus which is equipped with a hard polishing pad, and makes the surface flat, and the second polishing process eliminating the minute pit on the surface of a wafer using a wafer polishing apparatus equipped with a soft polishing pad, the surface of wafer is finished to be a flat and strain-free surface. It should be noted that since the kind of polishing pad used in the first polishing process and the second polishing process differs from each other, a wafer polishing apparatus for exclusive use is used in the first polishing process and the second polishing process, respectively.

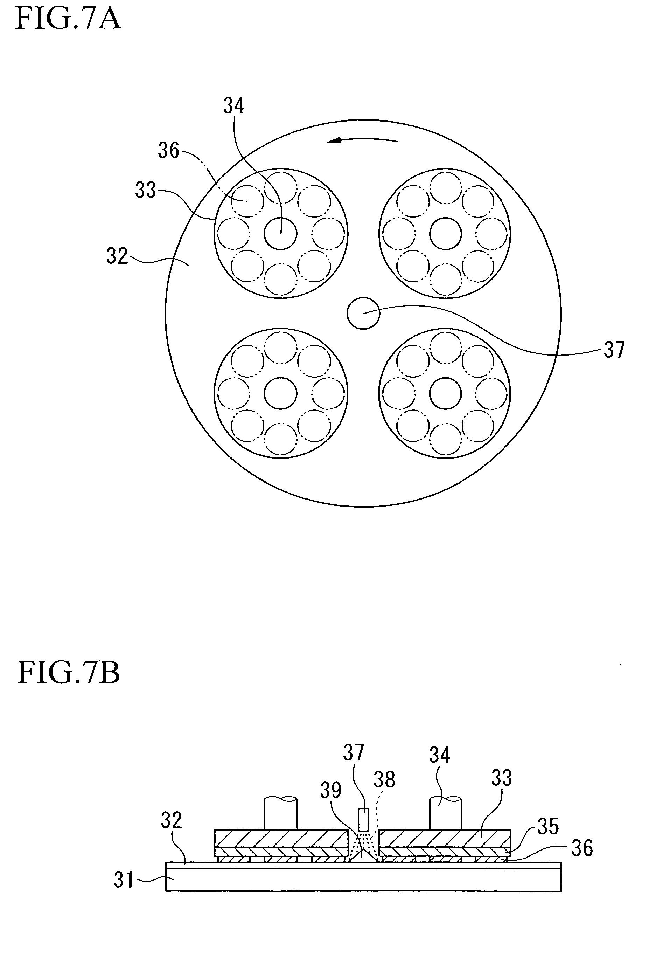

FIGS. 7A and 7B are figures showing a schematic view of a wafer polishing apparatus used in the conventional polishing method, and FIG.7A is a plan view thereof, and FIG. 7B is a side view thereof (for example, refer to Patent document 1).

A conventional wafer polishing apparatus consists of a rotation disk 31, a polishing pad 32 which is stuck on approximately whole surface of the rotation disk, plural rotation holders 33 disposed upward the rotation disk 31, and a wafer attachment plate 35 fixed to each rotation holders 33. The rotation holder 33 is constituted so that it can be driven up and down and rotated through a shaft 34. Plural wafers 36 are attached in the wafer attachment plate 35. It should be noted that the mark 37 denotes a pouring pipe, and it is also possible to polish wafers while supplying a rinsing liquid or a polishing liquid 38 through the pouring pipe 37, if needed.

[Patent document 1] Japanese Unexamined Patent Application, First Publication No.S64-78758 official report

However, there is a problem in that the manufacturing cost of wafers becomes expensive due to increasing of the equipment for polishing wafers and polishing materials in the conventional polishing method, because each of the first polishing process and the second polishing process is performed using a wafer polishing apparatus and a polishing pad for exclusive use. Moreover, since two polishing processes are performed while changing the wafer polishing equipment to be used, there is a problem in that the polishing process becomes complicated and it takes a long time for performing polishing process.

The present invention was made in view of the above circumstances, and it is an object of the present invention to provide an apparatus for polishing wafers which can reduce equipments for polishing wafers and materials for polishing, and which can simplify the polishing process and shorten the time for polishing, and a process for polishing wafers.

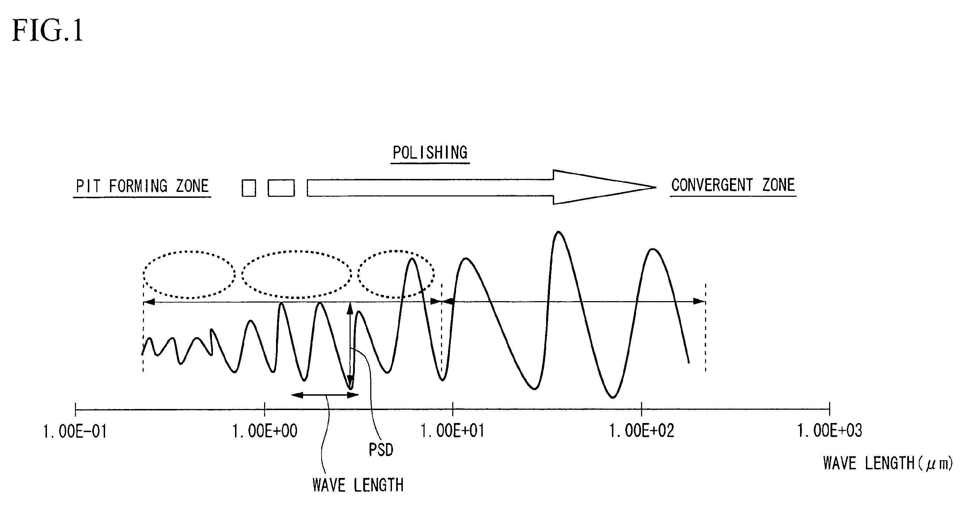

In order to solve the above problems, the inventors of the present invention have researched and repeated experiments thoroughly, and as a result, they have found that the coarseness component of the surface of wafer before being polished consists of a component with a large (for example, a wavelength over 10µm) wavelength and a component with a small (a wavelength under 10µm) wavelength in terms of the PSD (power spectral density) analysis as shown in FIG.1.

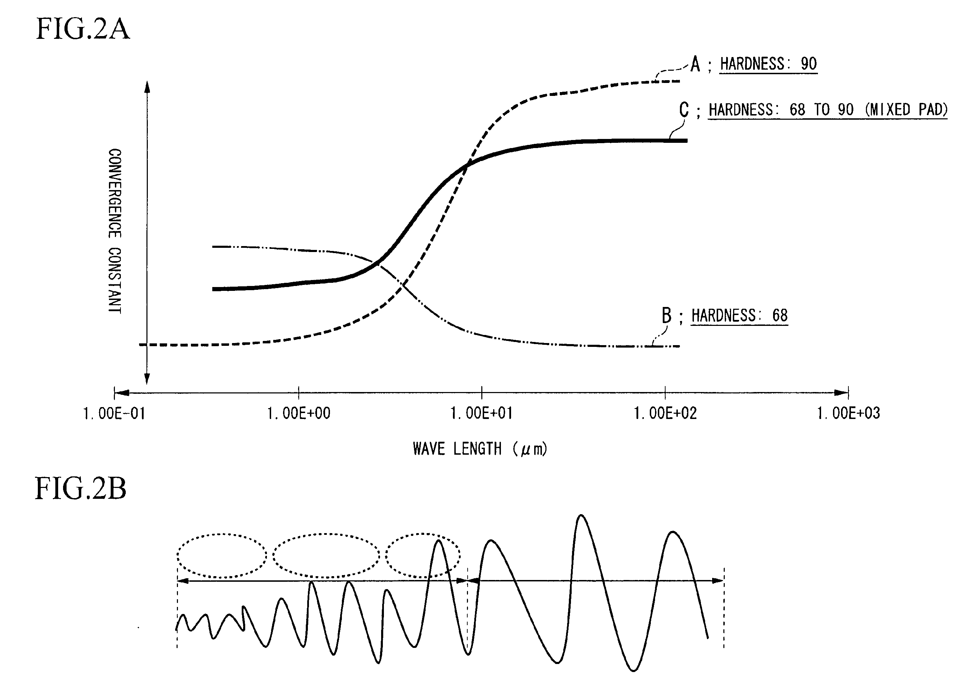

Moreover, it turned out that when the wafer surface is polished using a conventional hard polishing pad which is made of a foaming urethane with hardness of 90, as shown in the curve A in FIG. 2A, the component with a large wavelength can be removed in a short time (i.e. a convergence constant is large), whereas the convergence constant of a component with a short wavelength is small. Moreover, it turned out that when the wafer surface is polished using a conventional soft polishing pad which is made of suede with hardness of 68, as shown in the curve B of FIG. 2A, the component with a small wavelength can be removed in a short time (i.e. a convergence constant is large), whereas the convergence constant of a component with a large wavelength is small.

It should be noted that the convergence constant in the above is an inverse of time until the wafer surface is converted into a mirror surface, and the more the convergence constant is, the shorter the time until the wafer surface is converted into a mirror surface becomes, and the better the coefficient of polishing becomes.

Moreover, the hardness of the above polishing pad is the value measured by the spring type hardness meter (JIS-A type).

Furthermore, the inventors of the present invention have researched and repeated experiments thoroughly, and as a result, they have found that if the surface of a wafer is polished using a polishing pad (it may be referred as "a mixed pad") having both an area made of a hard polishing material and an area made of a soft polishing material, then the convergence constant of the component with a large wavelength becomes much greater than that of a conventional soft polishing pad, although the convergence constant of the component with a large wavelength becomes slightly smaller than that of a conventional hard polishing pad, as shown by the curve C in FIG.2A, whereas the convergence constant of the component with a small wavelength becomes much greater than that of a conventional hard polishing pad, although the convergence constant of the component with a small wavelength becomes slightly smaller than that of a conventional soft polishing pad, and that both a coarseness component with a large wavelength and a coarseness component with a small wavelength on the surface of a wafer can be removed efficiently using one apparatus for polishing wafer, thereby finishing to be a smooth and strain-free mirror surface, and thus they have completed the present invention. It should be noted that a graphic chart demonstrating the correlation between wavelength and coarseness component of wafer surface is shown in FIG.2B.

### SUMMARY OF THE INVENTION

The present invention provides an apparatus for polishing a wafer which polishes the wafer held by a carrier plate which rotates around an axis, by pressing and rubbing the wafer to a polishing pad disposed to a polishing platen which rotates around another axis which differs from said axis, wherein said polishing pad is equipped with plural areas including a first area and a second area having hardness different from each other, each of said first area and second area being formed at a distribution and/or an area ratio such that the rate of the time or distance that said wafer passes through said first area during polishing to the time or distance that said wafer passes through said second area during polishing becomes a predetermined value.

Moreover, in the apparatus for polishing a wafer of the present invention, each of said first area and said second area may be shaped into a planar sector, and said first area and said second area may be arranged alternately to constitute said plural areas.

Moreover, in the apparatus for polishing a wafer of the present invention, each of said first area and said second area may be shaped into a planar spiral, and said first area and said second area may be arranged alternately to constitute said plural areas.

The process for polishing a wafer of the present invention comprises rotating a polishing pad equipped with plural areas including a first area and a second area having hardness different from each other, and pressing and rubbing a wafer which rotates to said polishing pad thereby polishing surface of said wafer.

### BRIEF DESCRIPTION OF THE DRAWINGS

FIG. 1 is a graphic chart which shows the PSD analysis result of the coarseness of the surface of the wafer before being polished.
FIG. 2A is a graphic chart which shows the relation between a polishing pad and a convergence constant
FIG. 2B is a diagrammatic chart which shows the relation between the component of the coarseness of the surface of the wafer and a wavelength.
FIG. 3 is a principal part expanded sectional view of the apparatus for polishing a wafer of the preferred embodiment of the present invention.
FIG. 4 is a plan view of a polishing platen and a career plate disposed to the apparatus for polishing a wafer of FIG. 1.
FIG. 5 is a plan view of the polishing pad disposed to the apparatus for polishing a wafer of FIG. 1.
FIG. 6 is a graphic chart which shows polishing time of Comparative Example.
FIG. 7A is a plan view which shows a schematic constitution of a conventional wafer polishing apparatus.
FIG. 7B is a side view which shows a schematic constitution of a conventional wafer polishing apparatus.
FIG. 8 is a plan view showing another example of the polishing pad disposed to the apparatus for polishing a wafer of the present invention.
FIG. 9 is a plan view showing another example of the polishing pad disposed to the apparatus for polishing a wafer of the present invention.

### DETAILED DESCRIPTION OF THE INVENTION

Hereafter, embodiments of the apparatus for polishing a wafer of the present invention will be explained, based on drawings.

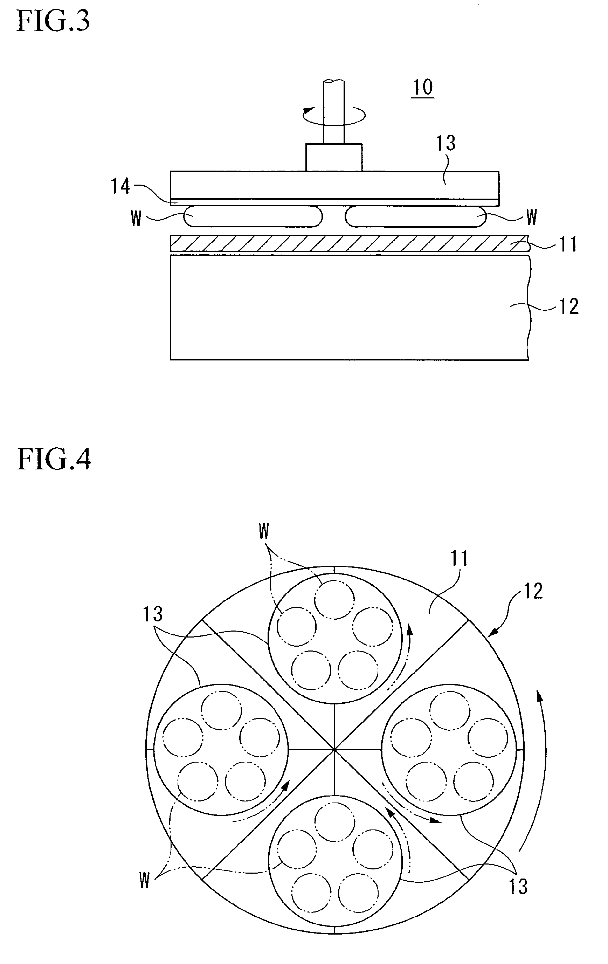

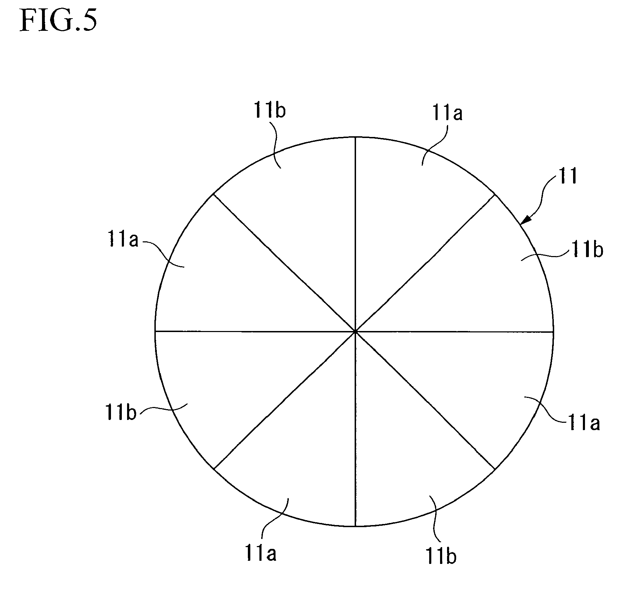

FIG. 3 is a principal part expanded sectional view of the apparatus for polishing a wafer of this embodiment, FIG. 4 is a plan view which shows the polishing platen disposed to the apparatus for polishing a wafer of FIG. 1 and a career plate, and FIG. 5 is a plan view of the polishing pad disposed to the apparatus for polishing a wafer of FIG. 1.

The apparatus for polishing a wafer 10 of this embodiment is equipped with a polishing platen 12 to the surface of which a planar circular polishing pad 11 consisting of plural areas is disposed, and plural (four in the drawing) polishing heads 13 disposed upwardly.

Each polishing head 13 is disposed rotatably around an axis. The career plate 14 is disposed to the surface opposed to the polishing platen of each polishing head 13, such that when the polishing head 13 rotates, the carrier plate 14 which is disposed to the polishing head 13 will also rotate around the axis. In this carrier plate 14, each of plural (i.e., 5 pieces in the drawing) silicon wafers is held at a predetermined interval (i.e., at 72° angular interval) around the center of the head. Silicon wafer W is, for example, one which was subjected to etching after being sliced or wrapped, and which necessitates to be subjected to be polishing process of polishing the surface to be mirror. As for the dimension of the silicon wafer W, one having a diameter of 300 mm and a thickness of 0.75 mm is used suitably, for example.

The polishing pad 11 is constituted from plural areas including a first area 11a and a second area 11b each of which hardness differs from each other.

The first area 11a and the second area 11b are formed at a distribution and/or an area ratio, such that the time or distance that wafer W passes through the first area 11a and the time or distance that wafer W passes through the second area 11b when polishing a wafer with the polishing pad 11becomes a predetermined rate.

Specifically, as it will be mentioned later, it is possible to set each of the first area 11a being hard and the second area 11b being soft, such that the length of trajectory formed when each of the first area 11a and the second area 11b passes a minute portion of wafer W during polishing process will be proportioned to the inverse of the hardness of each areas of 1 1a and 1 1b, for example, it is possible to set such that the formula (length of the first area 1 1a):(length of the second area 1 1b)=(hardness of the second area):(hardness of the first area) is satisfied, alternatively, the formula (time that the first area 1 1a passes through):(time that the second area 1 1b passes through)=(hardness of the second area):(hardness of the first area) is satisfied.

Alternatively, it is possible to set each of the first area 11a being hard and the second area 11b being soft, such that the length that the first area 11a passes through a certain portion of wafer W will be equivalent to the length that the second area 11b passes through the certain portion of wafer W during the polishing process, for example, it is possible to set such that the following formula [length of passing through the hard area]:[length of passing through the soft area] = 1:1 can be satisfied.

In this embodiment, as shown in FIG. 5, each of the planar sector-shaped first area 11a and the planar sector-shaped second area 11b is arranged alternately, thereby constituting a planar circular polishing pad 11. That is, the polishing pad 11 is divided into plural (i.e. eight pieces in the drawing) areas.

As for the first area 11a, material with hardness larger than that of the second area 11b is used, for example, the foaming urethane of hardness 90 is used.

As for the second area 11b, material with hardness smaller than that of the first area 11a, for example, suede and the nonwoven fabric of hardness 68 are used.

The hardness of the polishing pad 11 on which each of the first area 11a and the second area 11b is arranged alternately ranges from 68 to 90.

Although FIG. 5 shows the case in which the area ratio of the first area 11a and the second area 11b is 1:1, it is possible to make the area of the second area 11a having a small hardness larger than the area of the first area 11a having a large hardness.

In this case, it is possible to elongate the time or distance that the component with a small wavelength, which takes a time to be removed, of the coarseness component of the surface of the silicon wafer, passes through the second area 11b when polishing silicon wafer W with the polishing pad 11, and hence the removal efficiency of the coarseness component with a small wavelength can be increased.

The polishing platen 12 is disposed rotatably centering around another axis which is different from the above axis. The rotating direction of the polishing platen 12 is set to be the same as in each of the polishing head 13. It should be noted that the moving method of the polishing head 13 is not restricted to this embodiment.

The method for attaching the silicon wafer W to the career plate 14 may be either a wax adhering or a wax-less mounting method.

Next, a process for polishing silicon wafer W using this apparatus for polishing 10 will be explained.

As shown in FIGS. 3 and 4, at first, each of plural pieces (i.e. 5 pieces in the drawing) of silicon wafers W is stuck with wax at a predetermined interval (i.e. at 72° angular interval in the drawing) to each carrier plate 14, and then each carrier plate 14 is fixed to the lower surface of the polishing head 13 corresponding thereto.

And each polishing head 13 is lowered, thereby pressing each silicon wafer W to a polishing surface of the polishing pad 11 disposed to the polishing platen 12. The polishing platen 12 is rotated in the direction indicated by a solid line arrow of FIG. 4, while maintaining this state and supplying polish liquid to the polishing pad 11. Simultaneously, while rotating each polishing head 13 in the direction indicated by an alternate-long-and-two-short-dashes-line arrow of FIG. 4, each silicon wafer W is pressed and rubbed to the polishing pad 11, thereby polishing wafer W. In this polishing operation, the time or distance that the polished surface (surface) of wafer W passes through the first area 11a and the time or distance that the polished surface (surface) of wafer W passes through the second area 1 1b becomes a predetermined rate. For example, when the area ratio of the first area 1 1a to the second area 11b of the polishing pad 11 is 1:1, the ratio of the time or distance that the surface of the wafer W passes through the first area 1 1a to the time or distance that the surface of the wafer W passes through the second area 1 1b is 1:1. When the area of the second area 11b is larger than the area of the first area 11a, the time or distance that the surface of wafer W passes through the second area 11b becomes larger than the time or distance that the surface of wafer W passes through the first area 11a.

Thereby, the polished surface (surface) of each silicon wafer W is polished, and coarseness with a large (periodic time is large) wavelength and coarseness with a small (periodic time is small) wavelength existed on the wafer surface before being polished can be converged using one pad.

In the apparatus for polishing a wafer 10 in this embodiment, each of the first area 11a and the second area 11b differing in hardness is disposed alternately to the polishing pad 11 at a distribution and/or area ratio, such that the time or distance that the silicon wafer W passes through the first area 11a and the time or distance that the silicon wafer W passes through the second area 11b when polishing becomes a predetermined rate, and hence if polishing of wafer W is performed using this apparatus for polishing a wafer 10, then both coarse unevenness and minute pit on the surface of the wafer can be efficiently removed, thereby finishing into a smooth and strain-free mirror surface. That is, in accordance with the polishing using the apparatus for polishing a wafer in this embodiment, both coarse unevenness and minute pit (i.e. both a coarse component with a large wavelength and a coarse component with a small wavelength) on the surface of a wafer can be removed in the same process using one apparatus for polishing a wafer, and hence it is not necessary to change the apparatus for polishing a wafer and the polishing pad corresponding to the case of removing coarse unevenness and the case of eliminating minute pit as usual, and it is possible to reduce equipment for polishing a wafer and polishing material, thereby simplifying the polishing process and shortening the polishing period of a wafer, and as a result, a wafer can be efficiently polished.

Moreover, in accordance with the process for polishing a wafer in this embodiment, the polishing pad 11 which is equipped with plural areas including the first area 11a and the second area 11b each of which differs in hardness is rotated, and a rotating silicon wafer W is pressed and rubbed to the polishing pad 11, thereby removing both coarse unevenness and minute pit on the surface of the wafer with the polishing pad 11, and hence it is not necessary to change the apparatus for polishing a wafer and the polishing pad corresponding to the case of removing coarse unevenness and the case of eliminating minute pit as usual, and it is possible to reduce equipment for polishing a wafer and polishing material, thereby simplifying the polishing process and shortening the polishing period of a wafer, and as a result, a wafer can be efficiently polished.

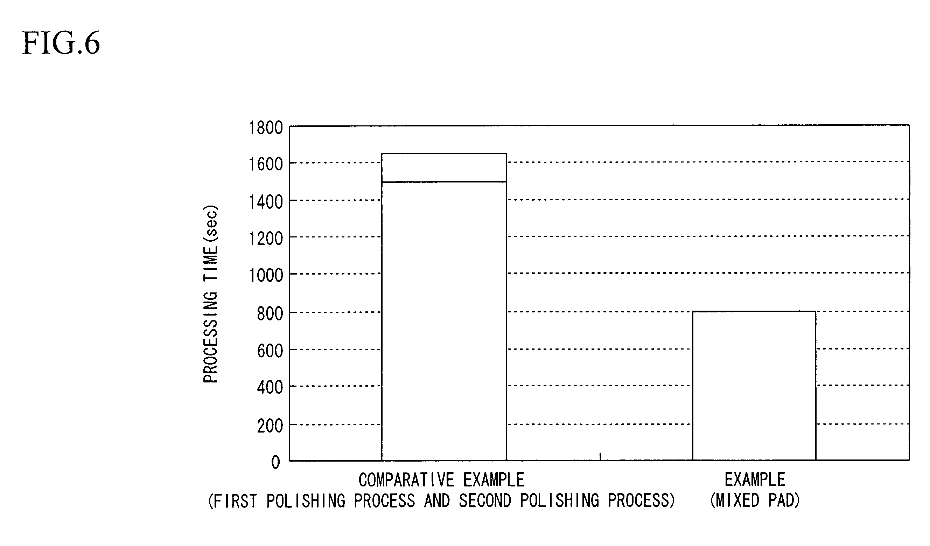

Specifically, the processing time in the case (i.e. in the case of performing a first polishing process using a hard polishing pad, and a second polishing process using a soft polishing pad, as Comparative Example) of polishing by changing apparatus for polishing a wafer which is used in the case of removing the coarse unevenness on the surface of a wafer and the polishing pad which is used in the case of removing a minute pit, as usual takes approximately 1650 seconds, as shown in FIG. 6. On the other hand, it is revealed that the processing time in the case of polishing the surface of wafer W using the apparatus for polishing a wafer 10 of the embodiment which is equipped with the polishing pad(i.e. mixed pad)11 to which each of the first area 11a and the second area 11b which differs in hardness is disposed alternately takes approximately 800 seconds as shown in FIG. 6, it is possible to make the time required for polishing a wafer 1/2 or less of that of Comparative Example, and that wafer can be polished efficiently.

In accordance with this embodiment, by performing processing corresponding to each coarseness component on one axis, the time required for polishing can be reduced to be half, an equipment therefor can also be reduced to be half, the polishing pad can also be reduced to be half, and the cost can be reduced.

It should be noted that although it is explained about the case in which the apparatus for polishing a wafer in the above embodiment is equipped with the polishing pad 11 which is constituted from eight areas in which each of the first area 11a being planar sector-shaped and the second area 11b being planar sector-shaped is disposed alternately, as for the polishing pad, any other polishing pad may be used as long as it consists of each of the first area and the second area which differs in hardness and arranged alternately, for example, the polishing pad may be constituted from two areas of a first area 11a which is planar semicircle-shaped and a second area 11b which is planar semicircle-shaped.

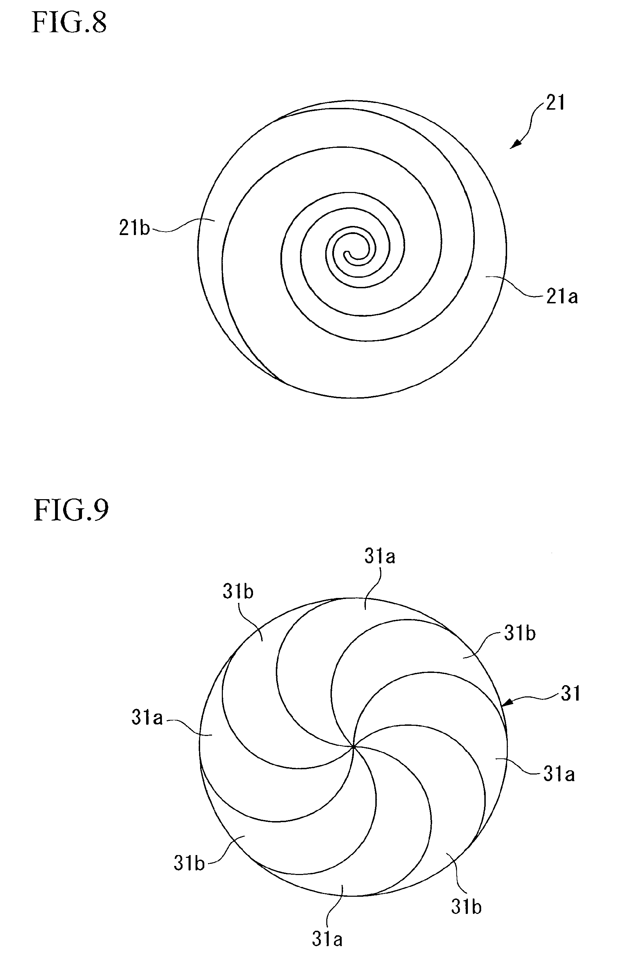

Moreover, as shown in FIG. 8, the polishing pad 21 may be constituted from plural areas consisting of the first area 2 1a and the second area 21 b, each of which has planar spiral-shape, differs in hardness and is arranged alternately.

Moreover, as shown in FIG. 9, the polishing pad 21 may be constituted from plural areas consisting of the first area 31a and the second area 31b, each of which has planar pinwheel-shape, differs in hardness and is arranged alternately.

In the apparatus for polishing a wafer in this embodiment, each of the first area and the second area differing in hardness is disposed alternately to the polishing pad at a distribution and/or area ratio, such that the time or distance that the silicon wafer passes through the first area and the time or distance that the silicon wafer passes through the second area when polishing becomes a predetermined rate, and hence if polishing of wafer is performed using this apparatus for polishing a wafer, then both coarse unevenness and minute pit on the surface of the wafer can be efficiently removed, thereby finishing into a smooth and strain-free mirror surface. That is, in accordance with the polishing using the apparatus for polishing a wafer in this embodiment, both coarse unevenness and minute pit (i.e. both a coarse component with a large wavelength and a coarse component with a small wavelength) on the surface of a wafer can be removed in the same process using one apparatus for polishing a wafer, and hence it is not necessary to change the apparatus for polishing a wafer and the polishing pad corresponding to the case of removing coarse unevenness and the case of eliminating minute pit as usual, and it is possible to reduce equipment for polishing a wafer and polishing material, thereby simplifying the polishing process and shortening the polishing period of a wafer, and as a result, a wafer can be efficiently polished.

Moreover, in accordance with the process for polishing a wafer in this embodiment, the polishing pad which is equipped with plural areas including the first area and the second area each of which differs in hardness is rotated, and a rotating silicon wafer is pressed and rubbed to the polishing pad , thereby removing both coarse unevenness and minute pit on the surface of the wafer with the polishing pad , and hence it is not necessary to change the apparatus for polishing a wafer and the polishing pad corresponding to the case of removing coarse unevenness and the case of eliminating minute pit as usual, and it is possible to reduce equipment for polishing a wafer and polishing material, thereby simplifying the polishing process and shortening the polishing period of a wafer, and as a result, a wafer can be efficiently polished.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. An apparatus for polishing a wafer which polishes the wafer held by a carrier plate which rotates around an axis, by pressing and rubbing the wafer to a polishing pad disposed to a polishing platen which rotates around another axis which differs from said axis,
wherein said polishing pad is equipped with plural areas including a first area and a second area having hardness different from each other, each of said first area and second area being formed at a distribution and/or an area ratio such that the rate of the time or distance that said wafer passes through said first area during polishing to the time or distance that said wafer passes through said second area during polishing becomes a predetermined value.

2. The apparatus for polishing a wafer as set forth in claim 1, wherein each of said first area and said second area is shaped into a planar sector, and said first area and said second area are arranged alternately to constitute said plural areas.

3. The apparatus for polishing a wafer as set forth in claim 1, wherein each of said first area and said second area is shaped into a planar spiral, and said first area and said second area are arranged alternately to constitute said plural areas.

4. A process for polishing a wafer comprising rotating a polishing pad equipped with plural areas including a first area and a second area having hardness different from each other, and pressing and rubbing a wafer which rotates to said polishing pad thereby polishing surface of said wafer.
